# FASCICULE DE BREVET EUROPEEN

(11) **EP 3 721 470 B1**
(45) Date de publication et mention de la délivrance du brevet: **14.08.2024**
(21) Numéro de dépôt: 18819196.9
(22) Date de dépôt: 21.11.2018
(51) Int. Cl.: H01L 21/304, H01L 21/18, H01L 21/78, H01L 21/02

(54) **PROCÉDÉ DE TRANSFERT D'UNE COUCHE UTILISANT UNE STRUCTURE DÉMONTABLE**
VERFAHREN ZUM ÜBERTRAGEN EINER SCHICHT UNTER VERWENDUNG EINER LÖSBAREN STRUKTUR
METHOD FOR TRANSFERRING A LAYER BY USING A DETACHABLE STRUCTURE

(30) Priorité: 07.12.2017 FR 1761759
(43) Date de publication de la demande: 14.10.2020
(73) Titulaire: Soitec, 38190 Bernin (FR)
(72) Inventeur: BRUEL, Michel, 38113 Veurey Voroize (FR)
(74) Mandataire: IP Trust
(86) Numéro de dépôt international: PCT/FR2018/052939
(87) Numéro de publication internationale: WO 2019/110886

(56) Documents cités:
- WO-A1-2011/131847
- US-A1- 2016 307 792
- US-A1- 2017 005 224
- US-B2- 7 951 691

## Description

### DOMAINE DE L'INVENTION

La présente invention concerne le domaine du transfert de couches minces pour les applications microélectroniques, optiques, microsystèmes... Elle concerne en particulier une structure démontable pouvant être utilisée pour le transfert ou la manipulation de couches minces.

### ARRIERE PLAN TECHNOLOGIQUE DE L'INVENTION

De nombreuses applications, notamment dans les domaines microélectroniques, optiques ou microsystèmes, requièrent des couches minces (intégrant potentiellement des composants) disposées sur des substrats spécifiques (fins, souples, métalliques, isolants, etc). Ces substrats spécifiques ne sont pas toujours compatibles avec les procédés de fabrication des couches minces et/ou les procédés d'intégration de composants sur lesdites couches.

Il est donc intéressant de pouvoir transférer une couche mince (avec ou sans des composants intégrés) d'un substrat initial compatible avec les procédés précédemment évoqués, vers un substrat spécifique cible présentant les propriétés requises pour l'application visée.

Il existe plusieurs procédés de transfert sur un substrat cible, d'une couche mince élaborée sur un substrat initial.

Certains procédés de transfert consistent à assembler la couche mince (disposée sur le substrat initial) et le substrat cible, puis à éliminer mécaniquement et/ou chimiquement le substrat initial, transférant ainsi la couche mince sur le substrat cible. Les inconvénients principaux de cette approche sont les couts liés à la perte du substrat initial et les traitements mécaniques et chimiques contraignants susceptibles de dégrader la qualité de la couche mince au cours du transfert.

D'autres procédés sont basés sur un détachement, par application d'une contrainte mécanique ou d'un traitement chimique au niveau d'une couche ou d'une interface fragilisée présente dans le substrat initial, entre la couche mince et le substrat initial ; la couche mince préalablement assemblée sur le substrat cible, est transférée sur ce dernier lorsque le détachement s'effectue. C'est notamment le cas des procédés décrits dans les documents FR2748851, FR2823599 ou FR2823596.

Les inconvénients de ces approches viennent essentiellement du fait que les étapes de détachement, par insertion d'une lame entre les substrats initial et cible assemblés, par application d'importantes contraintes en traction, et/ou par immersion dans une solution chimique, sont susceptibles de dégrader la qualité de la couche mince. Par ailleurs, le détachement peut parfois se faire au niveau d'interfaces ou de couches autres que celle fragilisée car la contrainte mécanique et/ou l'attaque chimique peuvent difficilement être précisément localisées au niveau de la couche ou interface fragilisée.

En outre, référence est faite aux documents suivants:
US 2017/005224 A1 (SHUR MICHAEL [US] ET AL) 5 janvier 2017
WO 2011/131847 A1 (COMMISSARIAT ENERGIE ATOMIQUE [FR]; TAUZIN AURELIE [FR]; STRAGIER ANNE) 27 octobre 2011
US 2016/307792 A1 (WERNER WOLFGANG [DE] ET AL) 20 octobre 2016
US 7 951 691 B2 (STUTTGART MIKROELEKTRONIK [DE]) 31 mai 2011 (2011-05-31)

Encore d'autres procédés, basés sur la séparation par laser au niveau d'une interface (« laser lift-off ») requièrent l'utilisation d'un substrat transparent (pour le substrat final ou pour le substrat support initial), ce qui limite le champ des applications.

### OBJET DE L'INVENTION

La présente invention concerne une solution alternative visant à pallier tout ou partie des inconvénients de l'état de la technique. Un objet de l'invention est une structure démontable au niveau d'une couche démontable, pouvant être utilisée pour le transfert ou la manipulation de couches.

### BREVE DESCRIPTION DE L'INVENTION

L'objet de l'invention est défini dans la revendication 1. Des modes de réalisations préférés sont donnés dans les revendications dépendantes.

La présente invention concerne un procédé de transfert d'une couche superficielle à partir d'une structure démontable comprenant les étapes suivantes :
a) Fournir la structure démontable comportant :
   - un substrat support,
   - une couche démontable disposée sur le substrat support selon un plan principal et comprenant une pluralité de parois disjointes les unes des autres, chaque paroi présentant au moins un flanc perpendiculaire au plan principal ;
   - une couche superficielle disposée sur la couche démontable selon le plan principal ;
b) Appliquer une sollicitation mécanique pour détacher la couche superficielle du substrat support ;
le procédé de transfert étant caractérisé en ce que :
- l'étape a) comprend le report de la couche superficielle sur la couche démontable par assemblage d'un substrat donneur sur la couche démontable et par amincissement dudit substrat donneur pour former la couche superficielle,
- chaque paroi de la couche démontable présente au moins un flanc perpendiculaire au plan principal (x,y),
- la sollicitation mécanique est configurée pour engendrer une flexion des parois, suivant une direction sécante audit flanc, jusqu'à provoquer la rupture mécanique desdites parois.

Selon des caractéristiques avantageuses de l'invention, prises seules ou selon toute combinaison réalisable dans le cadre de l'invention telle que définie à la revendication 1 :
- les parois sont réparties dans le plan principal selon un réseau prédéfini ;
- le réseau prédéfini de parois est tel qu'il existe au moins une direction transverse dans le plan principal formant un angle non nul avec un flanc de chaque paroi ;
- chaque paroi comprend deux flancs longitudinaux définis par une longueur et une hauteur de la paroi, et deux flancs transverses définis par une largeur et la hauteur de la paroi, les flancs longitudinaux et transverses étant perpendiculaires au plan principal ;
- la longueur de chaque paroi est supérieure à la largeur de chaque paroi, et la direction transverse forme un angle non nul avec un flanc longitudinal de chaque paroi ;
- la sollicitation mécanique de l'étape b) est une force en cisaillement appliquée à la couche démontable selon la direction transverse ;
- la force en cisaillement est appliquée au moyen d'un rouleau, avançant progressivement sur la structure démontable, dans le plan principal et selon la direction transverse, avec une force d'appui déterminée ;
- la sollicitation mécanique de l'étape b) est un choc appliqué à la structure démontable, selon la direction transverse ;
- la sollicitation mécanique de l'étape b) est une onde vibratoire appliquée à la structure démontable, selon la direction transverse, et apte à faire osciller les parois ;
- chaque paroi présente une largeur, dans le plan principal, comprise entre 0,1 et 10 microns ;
- la largeur de chaque paroi en partie inférieure à proximité du substrat support est inférieure à la largeur de chaque paroi en partie supérieure à proximité de la couche superficielle ;
- les parois présentent une hauteur, perpendiculaire au plan principal, comprise entre 0,5 et 5 microns ;
- chaque paroi présente une largeur dans le plan principal et une hauteur perpendiculaire au plan principal, et le ratio hauteur/largeur est supérieur à 1, préférentiellement supérieur à 5 ;
- la couche démontable de la structure démontable fournie à l'étape a) est formée par gravure locale d'une couche d'oxyde de silicium disposée sur le substrat support ;
- la couche démontable de la structure démontable fournie à l'étape a) est formée par gravure locale du substrat support ;
- le substrat support est en silicium ;
- l'étape a) comprend la réalisation de composants microélectroniques sur la couche superficielle ;
- le procédé de transfert comprend, préalablement à l'étape b), une étape de découpe de la couche superficielle pour délimiter une pluralité de couches superficielles locales à transférer ;
- le procédé de transfert comprend, préalablement à l'étape b), une étape a') comprenant l'assemblage de la couche superficielle sur un substrat cible ;
- le procédé de transfert comprend, après le détachement de la couche superficielle à l'étape b), une étape c) incluant le retrait de résidus de couche démontable pour exposer une face détachée de la couche superficielle ;
- l'étape c) comprend la réalisation d'étapes microélectroniques sur la face détachée de la couche superficielle.

### BREVE DESCRIPTION DES DESSINS

D'autres caractéristiques et avantages de l'invention ressortiront de la description détaillée qui va suivre en référence aux figures annexées sur lesquelles :
- la figure 1 présente une vue en coupe d'une structure démontable conforme à l'invention ;
- les figures 2a à 2f présentent une vue plane (selon le plan XY schématisé sur la figure 1 de différents exemples de couche démontable d'une structure démontable conforme à l'invention ;
- les figures 3 (a,b,c), 4 (a,b,c) et 5 (a,b,c) présentent des étapes de formation de la couche démontable d'une structure démontable conforme à l'invention ;
- la figure 6 (a,b,c,d) présente des étapes de fabrication d'une structure démontable conforme à l'invention ;
- les figures 7 (a,b,c), 8 (a,b,c) et 9 (a,b,c) présentent des étapes du procédé de transfert conforme à l'invention.

### DESCRIPTION DETAILLEE DE L'INVENTION

Dans la partie descriptive, les mêmes références sur les figures pourront être utilisées pour des éléments de même nature.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

L'invention concerne un procédé de transfert d'une couche superficielle 30 à partir d'une structure démontable 100.

Le procédé de transfert selon l'invention comprend en premier lieu une étape a) de fourniture de la structure démontable 100.

La structure démontable 100 comporte un substrat support 10. Ce dernier peut être choisi parmi des matériaux compatibles avec les procédés de fabrication microélectroniques (par exemple silicium, silice, verre...). Avantageusement, il est formé en silicium, matériau classiquement utilisé dans l'industrie des semi-conducteurs. Le substrat support 10 peut se présenter sous forme d'une plaquette de diamètre 100 à 450mm et d'épaisseur comprise entre 250 et 850 microns, par exemple.

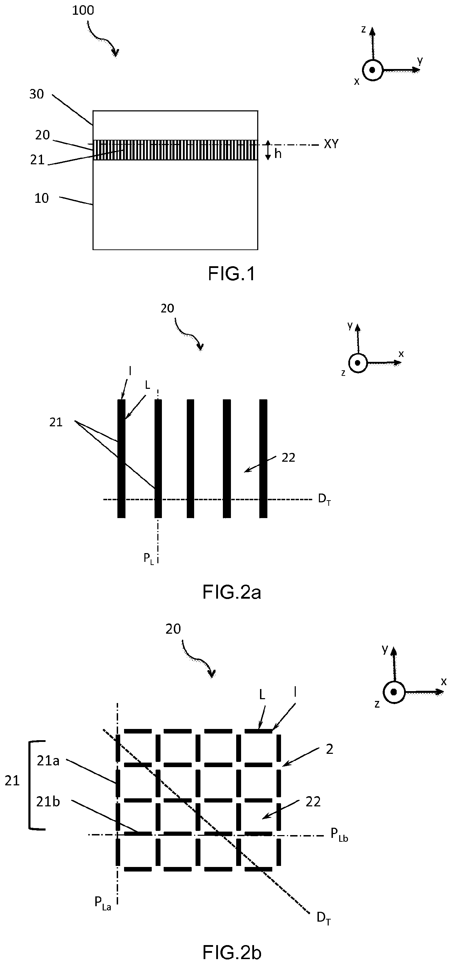

La structure démontable 100 comporte également une couche démontable 20, disposée sur le substrat support 10, selon un plan principal parallèle au plan (x,y) représenté sur la figure 1 ; pour simplifier, le plan principal sera nommé par la suite plan principal (x, y) .

La couche démontable 20 selon l'invention comprend une pluralité de parois 21, réparties dans le plan principal (x,y) et chaque paroi 21 présentant au moins un flanc perpendiculaire audit plan principal.

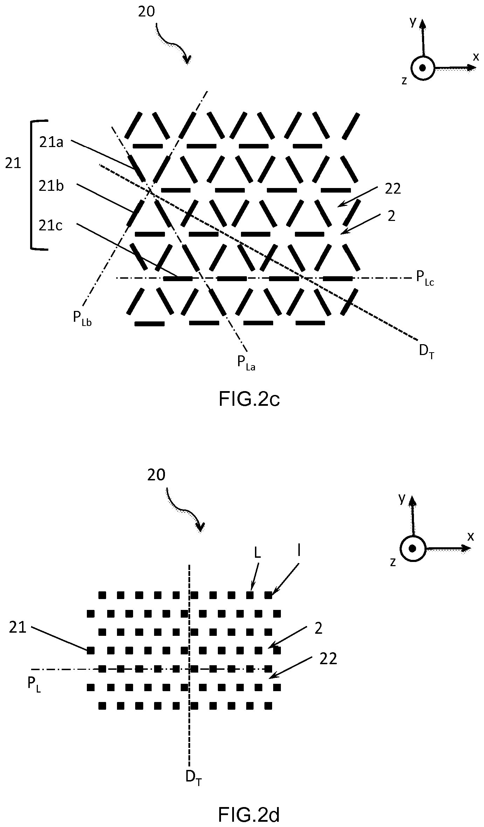

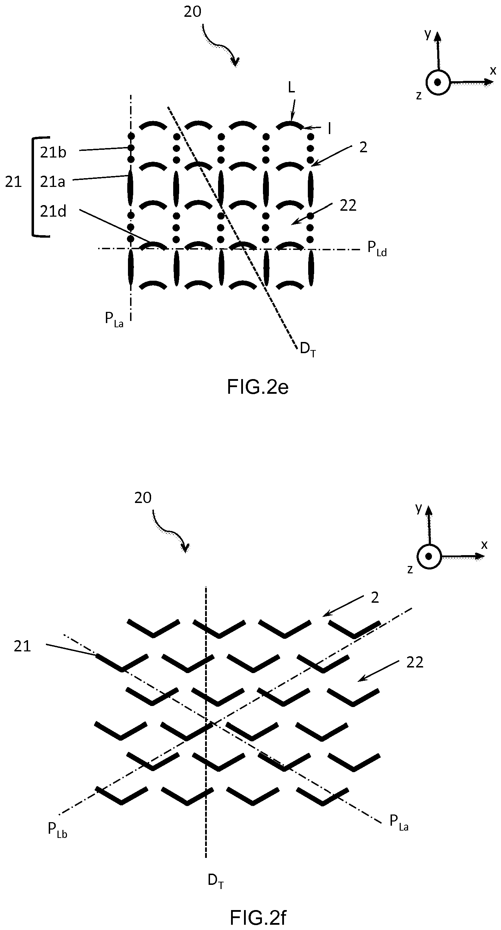

Chaque paroi 21 présente également une surface dite supérieure, en contact direct ou via une couche intermédiaire avec la couche superficielle 30, et une surface dite inférieure, en contact direct ou via une couche intermédiaire avec le substrat support 10. Ces surfaces inférieure et supérieure, parallèles au plan principal (x,y) peuvent présenter différentes formes : par exemple, carrée (figure 2d), rectangulaire (figures 2a, 2b, 2c), polygonale quelconque (figure 2f), circulaire (figure 2e), elliptique (figure 2e), courbée (figure 2e), etc. Les exemples de parois 21 illustrés sur les figures 2a à 2f sont des vues de dessus selon le plan de coupe XY noté sur la figure 1.

Selon la forme de ses surfaces inférieure et supérieure, chaque paroi 21 présente un flanc ou plusieurs flancs. Dans le cas particulier d'une paroi 21 de surfaces inférieure et supérieure circulaires, ladite paroi 21 forme un cylindre, le seul flanc de la paroi est donc la surface cylindrique perpendiculaire au plan principal (x,y). Une paroi 21 de surfaces inférieure et supérieure elliptique comporte deux flancs le long de la plus grande dimension de l'ellipse, flancs appelés longitudinaux. Enfin, la plupart des autres parois 21 comporte quatre flancs : deux flancs longitudinaux définis par la longueur L et la hauteur h de la paroi et deux flancs transverses définis par la largeur l et la hauteur h de la paroi 21. La longueur L et la largeur l de chaque paroi 21 sont parallèles au plan principal (x,y), la hauteur h s'étend selon l'axe z, perpendiculairement au plan principal (x,y).

Notons que les flancs longitudinaux de toutes les parois 21 ne sont pas nécessairement coplanaires, comme illustré sur les figures 2a à 2f.

A titre d'exemple, la longueur d'une paroi 21 pourra aller de quelques dizaines de microns à plusieurs centimètres, la largeur pourra aller de 0,1 microns à 10 microns, voire quelques dizaines de microns et la hauteur sera comprise entre environ 0,5 microns et 5 microns, voire supérieure à 5 microns. Avantageusement, le ratio hauteur/largeur de chaque paroi 21 est supérieur ou égal à 1, voire supérieur à 5.

Les parois 21 sont disjointes les unes des autres, leurs extrémités étant séparées entre elles par des espaces 2 (figures 2a à 2f) .

Avantageusement, les parois 21 sont réparties dans le plan principal (x,y) selon un réseau prédéfini. Par prédéfini, on entend que la répartition des parois 21, c'est-à-dire leur forme, leurs dispositions les unes par rapport aux autres et les espacements entre elles ne sont pas totalement aléatoires. Le réseau de parois 21 présente ainsi un certain caractère ordonné.

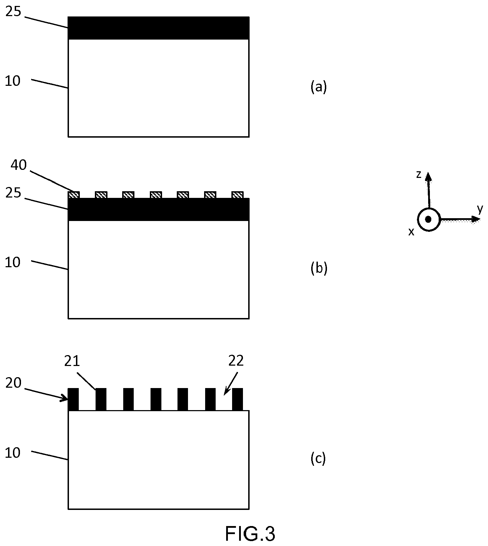

Selon une première option, la couche démontable 20 de la structure démontable 100 est formée par gravure locale d'une couche 25 disposée sur le substrat support 10 (figure 3). Ladite couche 25 est avantageusement composée d'oxyde de silicium. Elle est déposée sur le substrat support 10 (figure 3a), soit par croissance thermique dans le cas d'un substrat support 10 en silicium, soit par dépôt chimique (PECVD, LPCVD, etc). Un masque 40 disposé sur la surface de la couche d'oxyde de silicium 25 permet de masquer les zones où se situeront les parois 21 (figure 3b). Les zones non masquées sont gravées, par gravure sèche (par exemple, par plasma ou Reactive ion Etching (RIE)) ou humide (par exemple, par attaque chimique à base d'acide fluorhydrique). A l'issue de la gravure, le masque 40 est retiré et la couche démontable 20 est formée (figure 3c), avec des parois 21 disjointes (des espaces 2 existent entre les extrémités des parois) et séparées entre elles par des zones vides 22.

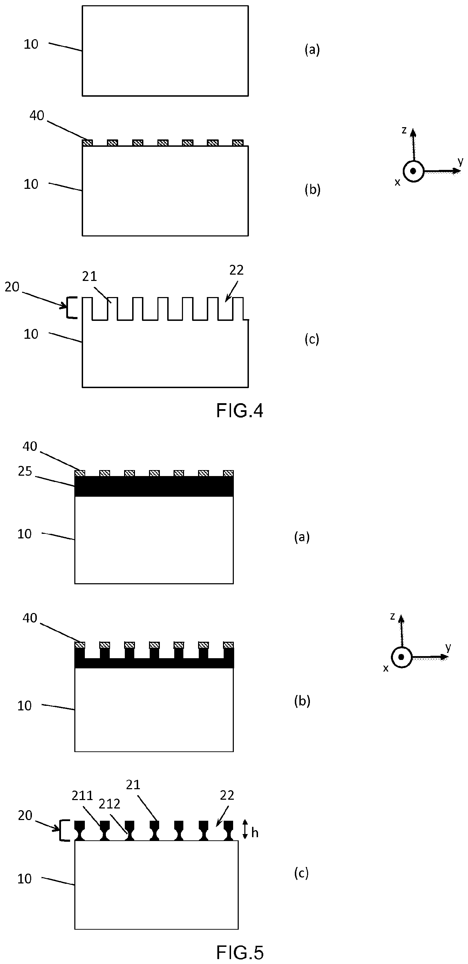

Selon une deuxième option, la couche démontable 20 de la structure démontable 100 fournie à l'étape a) est formée par gravure locale du substrat support 10 (figure 4). Un masque 40, disposé sur la surface du substrat support 10, permet de masquer les zones où se situeront les parois 21 (figure 4b). Les zones non masquées sont gravées, par gravure sèche ou humide. A l'issue de la gravure, le masque 40 est retiré et la couche démontable 20 est formée dans la partie supérieure du substrat support 10 (figure 3c), avec des parois 21 disjointes (des espaces 2 existent entre les extrémités des parois) et séparées entre elles par des zones vides 22.

Selon une troisième option, la couche démontable 20 fournie à l'étape a) présente une forme asymétrique suivant sa hauteur : avantageusement la largeur des parois 21 en partie inférieure 212 est plus faible que la largeur en partie supérieure 211.

La couche démontable 20 peut être formée par gravure locale soit d'une couche 25 disposée sur le substrat support 10 (comme illustré sur la figure 5), soit du substrat support 10 (non représenté). Un masque 40, disposé sur la surface de la couche 25, permet de masquer les zones où se situeront les parois 21 (figure 5a). Les zones non masquées sont gravées sur une première partie de l'épaisseur de la couche 25, par gravure anisotrope (par exemple par RIE) pour générer des flancs droits de parois 21 en partie supérieure 211 (figure 5b). Les zones non masquées sont ensuite gravées de manière isotrope (par exemple par gravure sèche isotrope ou gravure humide HF), pour former un étranglement en partie inférieure 212 de chaque paroi 21. Avantageusement, la partie inférieure 212 des parois 21 peut être gravée, sans attaquer la partie supérieure 211, grâce à l'utilisation pour la gravure anisotrope d'un procédé RIE dit polymérisant qui passive les flancs de la gravure et donc protège au moins partiellement la partie supérieure 211 de la gravure HF isotrope. A l'issue de ces étapes de gravure, le masque 40 est retiré et la couche démontable 20 est formée (figure 5c), avec des parois 21 de forme asymétrique, disjointes (des espaces 2 existent entre les extrémités des parois) et séparées entre elles par des zones vides 22.

Cette forme asymétrique des parois 21 est avantageuse en ce qu'elle procure, du fait de sa partie supérieure 211 plus large, une surface d'assemblage plus importante et donc un support mécanique plus favorable pour la couche superficielle 30, décrite ci-après, disposée sur la couche démontable 20. La forme asymétrique des parois 21 est également avantageuse en ce qu'elle favorise le détachement au niveau de la partie inférieure 212 du fait de l'étranglement ; l'étape de détachement sera décrite plus loin.

La structure démontable 100 comporte également une couche superficielle 30, disposée selon le plan principal (x,y) sur la couche démontable 20 (figure 1).

La couche superficielle 30, qui est destinée à être détachée de la structure démontable 100, peut présenter une épaisseur comprise entre quelques centaines de nanomètres et quelques centaines de microns, selon le domaine d'application. Elle peut consister en une couche vierge constituée d'un matériau ou d'un empilement de matériaux, et/ou en une couche structurée comportant ou non des composants. Le ou les matériaux constituant la couche superficielle 30 peuvent être choisis parmi des matériaux semi-conducteurs (par exemple, silicium, germanium, SiGe, SiC, etc), piézoélectriques (par exemple, quartz, LiTaO3, LiNbO3, AlN, etc), isolants, conducteurs, etc.

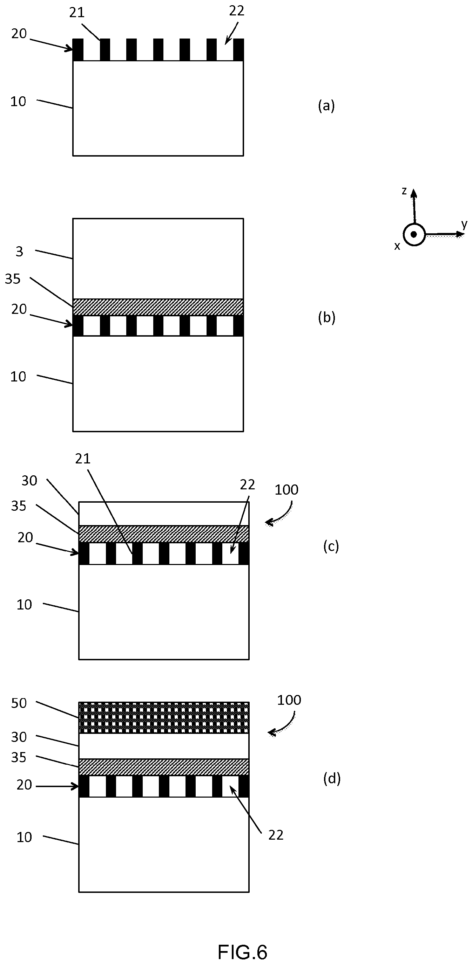

Selon l'invention, la fabrication de la couche superficielle 30 comporte une étape a) qui comprend le report de ladite couche superficielle 30 sur la couche démontable 20 (figure 6). Ce report peut être effectué par assemblage de la couche démontable disposée sur le substrat support 10 (figure 6a) avec un substrat donneur 3 (figure 6b) et par amincissement dudit substrat donneur 3 pour former la couche superficielle 30 (figure 6c).

L'assemblage peut être réalisé par toute technique de collage, compatible avec les traitements thermiques et chimiques visés pour la finition de la couche superficielle 30. En particulier, l'assemblage peut être réalisé par collage direct par adhésion moléculaire, technique bien connu de l'état de l'art. Facultativement, le substrat donneur 3 peut comporter une couche additionnelle 35 destinée à être directement assemblée avec la couche démontable 20 (figure 6b). La couche additionnelle 35 peut par exemple être formée en oxyde de silicium. Préalablement au collage, les surfaces à assembler peuvent subir des traitements secs (activation plasma, par exemple) et/ou humides (nettoyage chimiques) pour améliorer la qualité et la tenue de l'interface. Cette dernière est avantageusement consolidée par l'application d'un traitement thermique.

Le substrat donneur 3 subit ensuite une étape d'amincissement, à l'issue de laquelle la couche superficielle 30 sera formée (figure 6c). Cette étape d'amincissement peut être faite à partir de différentes techniques connues de l'art antérieur, notamment :
- le procédé Smart-Cut^{®}, particulièrement adapté à la formation de couches très fines (typiquement d'épaisseur inférieure ou égale à 1 micron) : il est basé sur une implantation d'espèces gazeuses dans le substrat donneur 3, au niveau de sa face à assembler, préalablement à l'étape d'assemblage, pour former un plan enterré fragilisé ; après assemblage, au cours d'une étape de fracture, le substrat donneur 3 se sépare le long du plan fragilisé, pour ne laisser solidaire du substrat support 10 que la couche mince 30.
- les procédés d'amincissement mécano-chimiques, incluant le rodage mécanique, le polissage mécano-chimique et la gravure chimique, surtout adaptés à la formation de couches d'épaisseurs comprises entre quelques microns et quelques dizaines, voire centaines de microns.

Bien-sur, les techniques énoncées ci-dessus ne sont pas exhaustives et d'autres techniques connues peuvent être utilisée pour l'amincissement du substrat donneur 3 et la finition de la couche superficielle 30.

Notons que la répartition des parois 21 dans le plan principal (x,y) de la couche démontable 20 pourra être adaptée à l'épaisseur et la rigidité de la couche superficielle 30 reportée. Pour une couche superficielle fine, on prendra soin de réduire les dimensions des zones 22 entre les parois 21 et des espaces 2 entre leurs extrémités.

La densité des parois 21 est choisie de sorte que la couche démontable 20 assure une bonne tenue mécanique de la couche superficielle 30 au cours des différents traitements (thermiques, mécaniques ou chimiques) qui lui seront appliqués pour sa fabrication. En particulier, les parois 21 couvrent entre 2% et 40% de la surface totale du substrat support 10, dans le plan principal (x, y).

Par ailleurs, la couche démontable 20 comportant des parois 21 disjointes, les zones vides 22 séparant les parois 21 communiquent entre elles et avec l'atmosphère extérieure à la structure 100. Partant de l'hypothèse que la couche démontable 20 est formée sur toute l'étendue de la structure démontable 100, il ne s'applique pas de différence de pression de part et d'autre de la couche superficielle 30, ce qui favorise la tenue mécanique de la couche superficielle 30 au cours de sa fabrication.

Selon une option de fabrication, l'étape a) comprend également la réalisation de composants microélectroniques 50 sur la couche superficielle 30 (figure 6d). Les composants microélectroniques 50 peuvent être des composants passifs ou actifs, élaborés par les techniques de fabrication habituelles du domaine semi-conducteur.

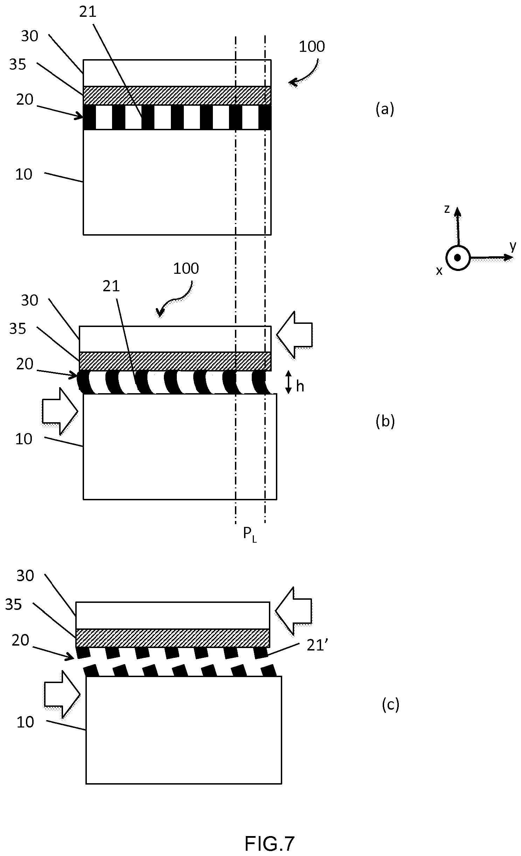

Le procédé de transfert selon l'invention comprend en second lieu une étape b) d'application d'une sollicitation mécanique à la structure démontable 100. Ladite sollicitation mécanique (illustrée par les flèches sur la figure 7b) est configurée pour engendrer une flexion des parois 21 de la couche démontable 20 (figure 7b), jusqu'à provoquer leur rupture mécanique (figure 7c) : cette rupture des parois 21 aboutit au détachement de la couche superficielle 30 du substrat support 10.

Par flexion d'une paroi 21, on entend une déformation d'au moins une partie du ou des flanc(s) (qui s'étendent verticalement suivant la hauteur) de la paroi 21. La flexion de la paroi 21 peut ainsi correspondre à une déformation par courbure de la paroi 21 suivant sa hauteur h (courbure simple concave, convexe ou complexe en S) ou à une déformation par basculement d'au moins une partie de la paroi 21 hors de sa position initiale.

La flexion de chaque paroi 21 s'opère selon une direction sécante au (au moins un) flanc de ladite paroi 21. Dans l'exemple illustré sur la figure 7, une déformation par courbure des parois 21 s'opère selon l'axe y, un flanc des parois 21 étant, en position initiale, parallèle au plan (x,z) .

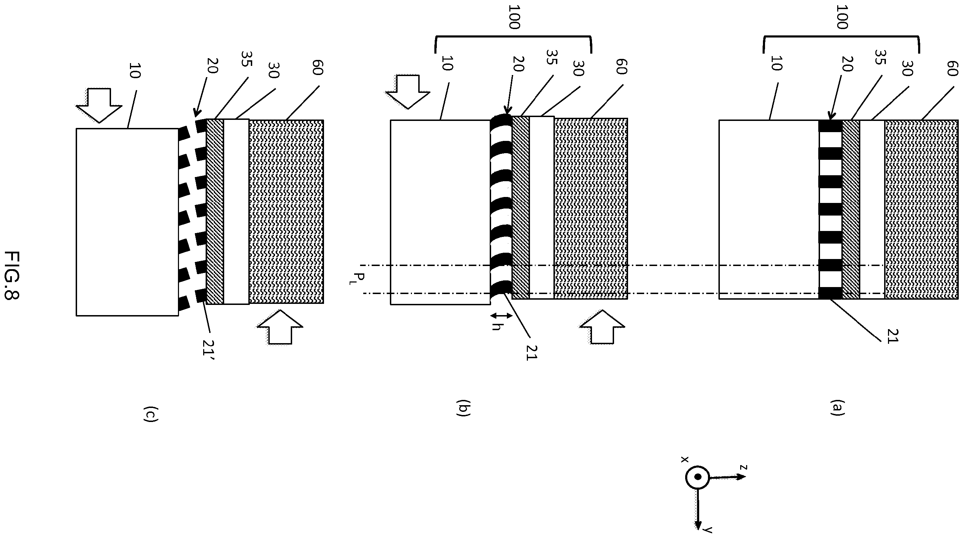

Optionnellement, le procédé de transfert selon l'invention comprend, préalablement à l'étape b), une étape a') comprenant l'assemblage de la couche superficielle 30 sur un substrat cible 60 (figure 8a).

Ce substrat cible 60 peut être choisi parmi l'ensemble des substrats disponibles dans les domaines d'application visés, compatibles avec un assemblage sur la couche superficielle 30. Les caractéristiques spécifiques (physiques, thermiques, électriques, etc) du substrat cible 60 sont choisies pour améliorer les performances des composants 50 déjà élaborés ou à élaborer sur la couche superficielle 30. Au terme de l'étape b) du procédé de transfert (figure 8b), la couche superficielle 30 sera détachée du substrat support 10 de la structure démontable 100 et transférée sur le substrat cible 60 (figure 8c).

Par exemple, dans le domaine des composants radiofréquences, il peut être intéressant de transférer une couche superficielle 30 munie de composants RF 50 sur un substrat cible 60 formé d'un matériau fortement isolant tel que le verre.

Dans le cadre du procédé de transfert selon l'invention, la présence du substrat cible 60 formant un support mécanique pour la couche superficielle 30, peut faciliter l'application de la sollicitation mécanique à la structure démontable 100.

Selon un premier mode de réalisation de l'étape b) du procédé de transfert, le réseau ordonné de parois 21 est tel qu'il existe au moins une direction transverse D_{T} dans le plan principal (x,y) formant un angle non nul avec un flanc de chaque paroi 21. Comme illustré sur les figures 2a à 2f, pour chaque réseau prédéfini de parois 21, il existe au moins une direction transverse D_{T} dans le plan principal (x,y) qui forme un angle non nul avec le (au moins un) flanc de chaque parois 21. Même si une seule direction transverse D_{T} a été schématisée, il est apparent sur les figures que d'autres directions transverses D_{T} existent.

Avantageusement, dans le cas de parois 21 dont la longueur est supérieure à la largeur et comportant des flans longitudinaux, on choisit la (au moins une) direction transverse D_{T} de sorte qu'elle forme un angle non nul avec un flanc longitudinal de chaque paroi 21. Plus précisément, la direction transverse D_{T} forme un angle non nul avec un plan longitudinal P_{L}, P_{La}, P_{Lb,} P_{Lc} dans lequel s'étend un flan longitudinal de chaque paroi 21, 21a, 21b, 21c (figures 2a, 2b, 2c, 2d, 2f) ou avec un plan longitudinal P_{Ld} passant par les extrémités de chaque paroi 21d (figure 2e).

Dans ce cas, la sollicitation mécanique de l'étape b) est avantageusement une force en cisaillement appliquée à la couche démontable 20 selon la (ou l'une des) direction(s) transverse(s) D_{T}.

En effet, chaque direction transverse D_{T} correspond à une direction de fragilité en cisaillement des parois 21 : une sollicitation mécanique en cisaillement de la couche démontable 20 va aisément induire la flexion de chaque paroi 21. Comme évoqué précédemment ladite flexion pourra se traduire par une déformation par courbure des flancs (préférentiellement longitudinaux) de la paroi 21 ou par basculement de la paroi 21 hors de sa position initiale.

A contrario, une sollicitation mécanique en cisaillement suivant une direction longitudinale c'est-à-dire incluse dans un plan longitudinal P_{L} ou coplanaire avec un plan longitudinal P_{L} présenterait une très faible efficacité pour induire une flexion de la paroi 21 : une telle direction longitudinale est, au contraire de la (ou des) direction(s) transverse(s) D_{T}, une direction de plus forte résistance en cisaillement de la couche démontable 20.

La couche démontable 20 peut être soumise à une force en cisaillement par application d'une force statique globale à la structure démontable 100 (force schématisée sur les figures 7a et 8a).

A titre d'exemple, un outil de préhension de la couche superficielle 20 ou du substrat cible 60 quand celui-ci est présent, et un outil de préhension du substrat support 10 peuvent exercer, chacun, une force en sens inverse, selon la direction transverse D_{T} choisie, de manière à générer une contrainte en cisaillement au niveau de la couche démontable 20. La contrainte de cisaillement induit la flexion des parois 21, jusqu'à leur rupture mécanique.

Selon une variante, la couche démontable 20 peut être soumise à une force en cisaillement par application d'une force statique progressive à la structure démontable 100.

En particulier, une telle force statique progressive peut être transmise au moyen d'un rouleau 5, avançant progressivement sur la structure démontable 100, dans le plan principal (x,y) et selon la direction transverse D_{T}, avec une force d'appui déterminée.

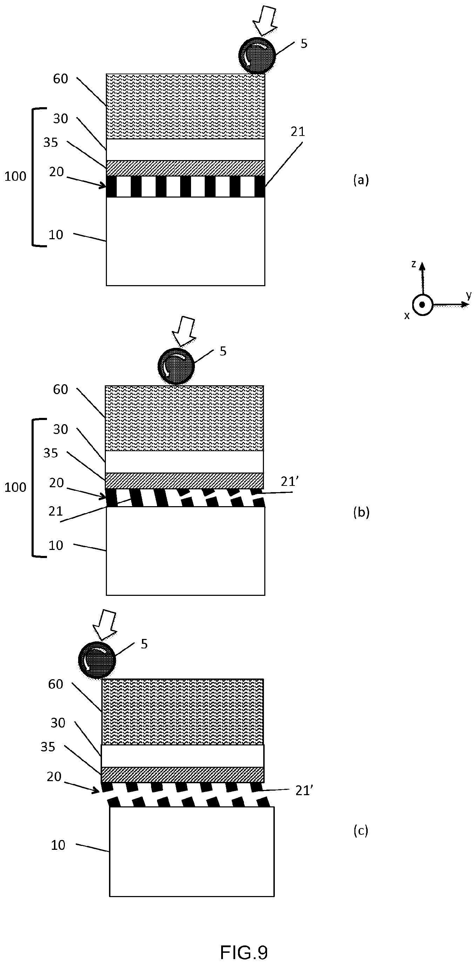

Dans l'exemple illustré en figure 9, un rouleau 5 est appuyé contre la face arrière du substrat cible 60 et avance progressivement sur ladite face arrière du fait de sa rotation (figure 9a). La face arrière du substrat support 10 de la structure démontable 100 est maintenue sur un support fixe. La force d'appui du rouleau 5, engendre un basculement ou un fléchissement des parois 21, au fur et à mesure de l'avancement du rouleau 5. La force d'appui est déterminée de manière à induire la rupture des parois. Comme schématisé sur les figures 9b et 9c, la rupture des parois 21 s'opère de proche en proche dans les zones de la couche démontable 20 sensiblement à l'aplomb du rouleau 5, jusqu'à détachement complet lorsque les parois 21 ont cédé sur toute l'étendue de la couche démontable 20.

Selon une autre variante, la sollicitation mécanique de l'étape b) est un choc appliqué à la structure démontable 100, selon la direction transverse D_{T}.

A titre d'exemple, ce choc peut être appliqué sur un bord de la structure démontable 100 et peut consister en une force appliquée ponctuellement et de manière limitée dans le temps (choc mécanique). Du fait de la brièveté de l'application de la force de choc (de l'ordre de la milliseconde), une onde de compression, dite onde de choc, se propage sur l'étendue de la structure démontable 100, induisant au fur et à mesure de sa progression une flexion des parois 21 de la couche démontable 20. La rupture mécanique des parois 21 va ainsi intervenir progressivement, au cours de la propagation de l'onde de choc.

Dans le premier mode de réalisation de l'étape b) du procédé de transfert, selon l'une ou l'autre des variantes précédemment décrites, prenons l'exemple d'une couche démontable 20 formée dans une structure démontable 100 présentant une surface totale de 100 cm². Les parois 21 présentent une hauteur de 5 microns, une largeur de 0,5 microns, une longueur de 10 cm, et sont espacées entre elles de 20 microns. La couche démontable 20 est ainsi formée d'environ cinq mille parois 21, de forme parallélépipédique. Les parois 21 sont en silicium.

Avec une force totale comprise entre 15 et 25 kN sur 100cm² (soit une force appliquée à chaque paroi 21 comprise entre environ 3 et 5 N), on atteint une déformation en flexion des parois 21 en silicium supérieure à leur résistance théorique à la rupture mécanique. Dans la pratique, une force totale significativement inférieure pourra mener à la rupture mécanique des parois 21 par flexion, du fait d'amorces de rupture introduites au cours de la fabrication des parois 21 et/ou grâce à l'utilisation de parois 21 de forme asymétrique, présentant des étranglements dans leurs parties inférieures 212.

Selon un deuxième mode de réalisation de l'étape b) du procédé de transfert, la sollicitation mécanique appliquée à la couche démontable 20 résulte d'une oscillation dont le mouvement se situe principalement dans le plan principal (x,y) . L'onde vibratoire est apte à faire osciller les parois 21.

A titre d'exemple, une platine vibrante sur laquelle le substrat support 10 est fixé pourra être utilisée. Le mouvement d'oscillation de la platine est préférentiellement effectué selon la direction transverse D_{T} de fragilité de la couche démontable 20.

L' oscillation va induire des flexions répétées de chaque paroi 21 : chaque paroi 21 est alors soumise à d'importantes forces inertielles, du fait de la masse de la couche superficielle 20 et potentiellement du substrat cible 60 disposés au-dessus de la couche démontable 20.

Reprenons, dans le contexte de ce deuxième mode de réalisation, l'exemple de la couche démontable 20 citée précédemment : une structure démontable 100 présentant une surface totale de 100 cm²; des parois 21 en silicium présentant une hauteur de 5 microns, une largeur de 0,5 microns, une longueur de 10 cm, et espacées entre elles de 20 microns. Considérons une couche superficielle 30 en silicium dont l'épaisseur varie de 0,1 à 100 microns.

Une onde vibratoire imposant une amplitude d'oscillation des parois de l'ordre de 1 micron, et dont la fréquence est choisie autour de la fréquence de résonnance, entre environ 19MHz (pour la couche superficielle de 0,1 microns) et environ 420kHz (pour la couche superficielle de 100 microns), serait apte à générer une force inertielle de l'ordre de 3 N appliquée à chaque paroi 21. Comme énoncé précédemment, avec une telle force, on atteint une déformation des parois 21 en silicium supérieure à leur résistance théorique à la rupture mécanique.

Ainsi, dans le premier ou le deuxième mode de réalisation de l'étape b) du procédé de transfert, la sollicitation mécanique configurée pour engendrer une flexion des parois 21 présente une amplitude raisonnable du fait des caractéristiques particulières de la couche démontable 20. Cela est favorable pour conserver l'intégrité de la couche superficielle 30 au cours du procédé de transfert et notamment lors de son détachement du substrat support 10. De plus, la sollicitation mécanique appliquée à la structure démontable 100 ne présentant pas (ou peu) de composante de traction (selon l'axe z dans les figures), il y a moins de risques d'endommager la couche superficielle 30 au cours du transfert. En outre, la force totale des sollicitations mécaniques, principalement en cisaillement, nécessaire pour détacher la couche superficielle 30, et largement inférieure à la force d'arrachement par traction qu'il serait nécessaire d'appliquer pour séparer la couche superficielle 30.

Avantageusement, le procédé de transfert selon l'invention comprend, après le détachement de la couche superficielle 30 à l'étape b), une étape c) incluant le retrait de résidus 21' de couche démontable 20 (figures 7c, 8c, 9c). Le retrait des résidus 21' de couche démontable peut consister notamment en une gravure desdits résidus 21' suivie d'un nettoyage de manière à exposer une face détachée de la couche superficielle 30. Cette face détachée est soit directement une surface de ladite couche 30, soit une surface de la couche additionnelle 35 introduite lors du report de la couche superficielle 30 sur la couche démontable 20 pour former la structure démontable 100.

Avantageusement, l'étape c) comprend également le retrait des résidus de couche démontable 20 restant sur le substrat support 10. Ce dernier peut ainsi être réutilisé pour former une nouvelle structure démontable 100.

Optionnellement, l'étape c) comprend la réalisation d'étapes microélectroniques sur la face détachée de la couche superficielle 30.

Ces étapes peuvent consister :
- à réaliser tout ou partie de composants sur la face détachée de la couche superficielle 30 (soit directement sur la surface libre de la couche superficielle 30, soit sur la surface libre de la couche additionnelle 35) ;
- ou à réaliser tout ou partie de composants sur la face détachée de la couche superficielle 30, en vis-à-vis de composants 50 déjà présents sur la face opposée de la couche superficielle 30, pour élaborer par exemple des transistors CMOS à double grille ;
- ou encore à reprendre des contacts électriques sur la face détachée de la couche superficielle 30, connectés à des composants 50 déjà présents sur l'autre surface de la couche superficielle 30.

De manière générale, le présent procédé de transfert peut répondre à un grand nombre d'applications requérant le transfert ou la manipulation de couches superficielles 30.

Les couches superficielles 30 peuvent être transférées ou manipulées sous forme de couches de grandes dimensions, c'est-à-dire de la dimension d'une plaquette par exemple circulaire de 100mm à 450 mm de diamètre.

Des couches superficielles 30 locales incluses dans une couche superficielle totale peuvent également être transférées ou manipulées individuellement, sous forme de puces ; les puces présentent par exemple des dimensions de quelques centaines de microns à quelques millimètres de côté.

Dans ce cas, l'étape a) de fourniture de la structure démontable 100 comportant la couche superficielle totale (et potentiellement des composants 50) comprend une étape de découpe pour délimiter chaque couche superficielle locale 30 à transférer. Les chemins de découpe s'étendent sur toute l'épaisseur de la couche superficielle et avantageusement entament ou traversent complètement la couche démontable 20. Optionnellement, les chemins de découpe peuvent également entamer le substrat support 10.

Au cours de l'étape b), la sollicitation mécanique est appliquée à au moins une couche superficielle locale 30. Il est ainsi possible de détacher localement des puces individuelles (zones locales de la couche superficielle totale) de la structure démontable 100.

Par exemple dans le cas d'une sollicitation mécanique sous forme d'onde vibratoire, on pourra appliquer une charge sur la couche superficielle locale (puce) que l'on souhaite détacher ; l'application locale d'une charge pourra s'opérer par ajout d'une masse définie, via un dépôt de couche spécifique, ou par un appui mécanique ponctuel. Une vibration à une fréquence correspondant à la fréquence de résonnance des parois 21 sous-jacentes à la couche superficielle locale (laquelle fréquence de résonnance dépend de la masse des couches au-dessus des parois 21) permettra de faire osciller les parois 21 sous-jacentes à ladite couche superficielle locale, jusqu'à leur rupture. On peut ainsi démonter individuellement les puces de la structure démontable 100.

Bien-sur, l'invention n'est pas limitée aux modes de réalisation décrits et on peut y apporter des variantes de réalisation sans sortir du cadre de l'invention tel que défini par les revendications.

## Revendications

1. Procédé de transfert d'une couche superficielle (30) à partir d'une structure démontable (100) comprenant les étapes suivantes :
a) Fournir la structure démontable (100) comportant :
• un substrat support (10),
• une couche démontable (20) disposée sur le substrat support (10) selon un plan principal (x,y) et comprenant une pluralité de parois (21) disjointes les unes des autres,
• une couche superficielle (30) disposée sur la couche démontable (20) selon le plan principal (x, y),
b) Appliquer une sollicitation mécanique pour détacher la couche superficielle (30) du substrat support (10) ;
le procédé de transfert étant **caractérisé en ce que** :
- l'étape a) comprend le report de la couche superficielle (30) sur la couche démontable (20) par assemblage d'un substrat donneur (3) sur la couche démontable (20) et par amincissement dudit substrat donneur (3) pour former la couche superficielle (30),
- chaque paroi (21) de la couche démontable (20) présente au moins un flanc perpendiculaire au plan principal (x,y),
- la sollicitation mécanique est configurée pour engendrer une flexion des parois (21), suivant une direction sécante audit flanc, jusqu'à provoquer la rupture mécanique desdites parois (21).

2. Procédé de transfert selon la revendication précédente, dans lequel les parois (21) sont réparties dans le plan principal (x,y) selon un réseau prédéfini.

3. Procédé de transfert selon la revendication précédente, dans lequel le réseau prédéfini de parois (21) est tel qu'il existe au moins une direction transverse (D_{T}) dans le plan principal (x,y) formant un angle non nul avec un flanc de chaque paroi (21).

4. Procédé de transfert selon la revendication précédente, dans lequel chaque paroi (21) comprend deux flancs longitudinaux définis par une longueur (L) et une hauteur de la paroi (h), et deux flancs transverses définis par une largeur (l) et la hauteur (h) de la paroi (21), les flancs longitudinaux et transverses étant perpendiculaires au plan principal (x,y).

5. Procédé de transfert selon la revendication précédente, dans lequel la longueur (L) de chaque paroi (21) est supérieure à la largeur (l) de chaque paroi (21), et dans lequel la direction transverse (D_{T}) forme un angle non nul avec un flanc longitudinal de chaque paroi (21).

6. Procédé de transfert selon l'une des revendications 3 à 5, dans lequel la sollicitation mécanique de l'étape b) est une force en cisaillement appliquée à la couche démontable (20) selon la direction transverse (D_{T}).

7. Procédé de transfert selon la revendication précédente, dans lequel la force en cisaillement est appliquée au moyen d'un rouleau (5), avançant progressivement sur la structure démontable (100), dans le plan principal (x,y) et selon la direction transverse (D_{T}), avec une force d'appui déterminée.

8. Procédé de transfert selon l'une des revendications 3 à 5, dans lequel la sollicitation mécanique de l'étape b) est un choc appliqué à la structure démontable (100), selon la direction transverse (D_{T}).

9. Procédé de transfert selon l'une des revendications 3 à 5, dans lequel la sollicitation mécanique de l'étape b) est une onde vibratoire appliquée à la structure démontable (100), selon la direction transverse (D_{T}), et apte à faire osciller les parois (21).

10. Procédé de transfert selon l'une des revendications précédentes, dans lequel chaque paroi (21) présente une largeur (l), dans le plan principal (x,y), comprise entre 0,1 et 10 microns.

11. Procédé de transfert selon l'une des revendications précédentes, dans lequel la largeur de chaque paroi (21) en partie inférieure (212) à proximité du substrat support (10) est inférieure à la largeur de chaque paroi (21) en partie supérieure (211) à proximité de la couche superficielle (30).

12. Procédé de transfert selon l'une des revendications précédentes, dans lequel les parois (21) présentent une hauteur (h), perpendiculaire au plan principal (x,y), comprise entre 0,5 et 5 microns.

13. Procédé de transfert selon l'une des revendications précédentes, dans lequel chaque paroi (21) présente une largeur (l) dans le plan principal (x,y) et une hauteur (h) perpendiculaire au plan principal (x,y) et dans lequel le ratio hauteur/largeur est supérieur à 1, préférentiellement supérieur à 5.

14. Procédé de transfert selon l'une des revendications précédentes, dans lequel la couche démontable (20) de la structure démontable (100) fournie à l'étape a) est formée par gravure locale d'une couche d'oxyde de silicium (25) disposée sur le substrat support (10).

15. Procédé de transfert selon l'une des revendications 1 à 13, dans lequel la couche démontable (20) de la structure démontable (100) fournie à l'étape a) est formée par gravure locale du substrat support (10).

16. Procédé de transfert selon l'une des revendications précédentes, dans lequel l'étape a) comprend la réalisation de composants microélectroniques (50) sur la couche superficielle (30).

17. Procédé de transfert selon l'une des revendications précédentes, comprenant, préalablement à l'étape b), une étape de découpe de la couche superficielle (30) pour délimiter une pluralité de couches superficielles locales à transférer.

## Patentansprüche

1. Verfahren zum Übertragen einer Grenzschicht (30) von einem entfernbaren Substrat (100), umfassend die folgenden Schritte:
a) Bereitstellen der entfernbaren Struktur (100), die aufweist:
• ein Trägersubstrat (10),
• eine entfernbare Schicht (20), die auf dem Trägersubstrat (10) entlang einer Hauptebene (x, y) angeordnet ist und eine Vielzahl von voneinander getrennten Wänden (21) umfasst,
• eine auf der entfernbaren Schicht (20) entlang der Hauptebene (x, y) angeordnete Grenzschicht (30),
b) Anwenden einer mechanischen Beanspruchung, um die Grenzschicht (30) von dem Trägersubstrat (10) zu lösen;
wobei das Übertragungsverfahren **dadurch gekennzeichnet ist, dass:**
- Schritt a) das Verschieben der Grenzschicht (30) auf die entfernbare Schicht (20) durch Anordnen eines Donorsubstrats (3) auf der entfernbaren Schicht (20) und durch Verjüngen des Donorsubstrats (3), um die Grenzschicht auszubilden (30), umfasst,
- jede Wand (21) der entfernbaren Schicht (20) mindestens eine Seite senkrecht zu der Hauptebene (x,y) vorweist,
- die mechanische Beanspruchung konfiguriert ist, um eine Biegung der Wände (21), die einer die Seite schneidenden Richtung folgt, bis sie den mechanischen Bruch der Wände (21) hervorruft.

2. Übertragungsverfahren nach dem vorstehenden Anspruch, wobei die Wände (21) in der Hauptebene (x,y) gemäß einem vordefinierten Gitter verteilt sind.

3. Übertragungsverfahren nach dem vorstehenden Anspruch, wobei das vordefinierte Gitter von Wänden (21) so ist, dass es in der Hauptebene (x,y) mindestens eine Querrichtung (D_{T}) gibt, die mit einer Seite jeder Wand (21) einen Winkel ungleich Null ausbildet.

4. Übertragungsverfahren nach dem vorstehenden Anspruch, wobei jede Wand (21) zwei Längsseiten, die durch eine Länge (L) und eine Höhe der Wand (h) definiert sind, und zwei Querseiten umfasst, die durch eine Breite (I) und die Höhe (h) der Wand (21) definiert sind, wobei die Längs- und die Querseiten senkrecht zu der Hauptebene (x,y) stehen.

5. Übertragungsverfahren nach dem vorstehenden Anspruch, wobei die Länge (L) jeder Wand (21) größer als die Breite (I) jeder Wand (21) ist und wobei die Querrichtung (D_{T}) mit einer Längsseite jeder Wand (21) einen Winkel ungleich Null ausbildet.

6. Übertragungsverfahren nach einem der Ansprüche 3 bis 5, wobei die mechanische Belastung von Schritt b) eine auf die entfernbare Schicht (20) in der Querrichtung (D_{T}) ausgeübte Scherkraft ist.

7. Übertragungsverfahren nach dem vorstehenden Anspruch, wobei die Scherkraft mittels einer Walze (5) ausgeübt wird, die sich allmählich auf der entfernbaren Struktur (100) in der Hauptebene (x,y) und in der Querrichtung (D_{T}) mit einer bestimmten Stützkraft fortbewegt.

8. Übertragungsverfahren nach einem der Ansprüche 3 bis 5, wobei die mechanische Belastung von Schritt b) ein auf die entfernbare Schicht (100) in der Querrichtung (D_{T}) ausgeübter Stoß ist.

9. Übertragungsverfahren nach einem der Ansprüche 3 bis 5, wobei die mechanische Belastung von Schritt b) eine Schwingungswelle ist, die in der Querrichtung (D_{T}) auf die abnehmbare Struktur (100) ausgeübt wird und geeignet ist, die Wände (21) oszillieren zu lassen.

10. Übertragungsverfahren nach einem der vorstehenden Ansprüche, wobei jede Wand (21) in der Hauptebene (x,y) eine Breite (I) zwischen 0,1 und 10 Mikrometern vorweist.

11. Übertragungsverfahren nach einem der vorstehenden Ansprüche, wobei die Breite jeder Wand (21) in einem unteren Teil (212) nahe dem Trägersubstrat (10) kleiner als die Breite jeder Wand (21) in einem oberen Teil (211) nahe der Grenzschicht (30) ist.

12. Übertragungsverfahren nach einem der vorstehenden Ansprüche, wobei die Wände (21) eine Höhe (h) senkrecht zu der Hauptebene (x,y) zwischen 0,5 und 5 Mikrometern vorweisen.

13. Übertragungsverfahren nach einem der vorstehenden Ansprüche, wobei jede Wand (21) eine Breite (I) in der Hauptebene (x,y) und eine Höhe (h) senkrecht zu der Hauptebene (x,y) vorweist, und wobei das Verhältnis Höhe/Breite größer als 1, vorzugsweise größer als 5, ist.

14. Übertragungsverfahren nach einem der vorstehenden Ansprüche, wobei die entfernbare Schicht (20) der entfernbaren Struktur (100), die in Schritt a) bereitgestellt ist, durch lokales Ätzen einer auf dem Trägersubstrat (10) angeordneten Schicht aus Siliziumoxid (25) ausgebildet wird.

15. Übertragungsverfahren nach einem der Ansprüche 1 bis 13, wobei die entfernbare Schicht (20) der entfernbaren Struktur (100), die in Schritt a) bereitgestellt ist, durch lokales Ätzen des Trägersubstrats (10) ausgebildet wird.

16. Übertragungsverfahren nach einem der vorstehenden Ansprüche, wobei Schritt a) das Herstellen mikroelektronischer Bauelemente (50) auf der Grenzschicht (30) umfasst.

17. Übertragungsverfahren nach einem der vorstehenden Ansprüche, umfassend, vor Schritt b), einen Schritt eines Schneidens der Grenzschicht (30), um eine Vielzahl lokaler Grenzschichten abzugrenzen, die zu übertragen sind.

## Claims

1. Method for transferring a superficial layer (30) from a detachable structure (100) comprising the following steps:
a) supplying the detachable structure (100) comprising:
• a support substrate (10),
• a detachable layer (20) arranged on the support substrate (10) along a main plane (x, y) and comprising a plurality of walls (21) that are separated from one another,
• a superficial layer (30) arranged on the detachable layer (20) along the main plane (x, y),
b) applying a mechanical stress in order to detach the superficial layer (30) from the support substrate (10);
the transfer method being **characterized in that:**
- step a) comprises transferring the superficial layer (30) onto the detachable layer (20) by assembling a donor substrate (3) on the detachable layer (20) and by thinning said donor substrate (3) in order to form the superficial layer (30),
- each wall (21) of the detachable layer (20) has at least one flank perpendicular to the main plane (x, y),
- the mechanical stress is designed to cause the walls (21) to bend in a direction intersecting said flank, until said walls (21) mechanically break.

2. Transfer method according to the preceding claim, wherein the walls (21) are distributed in the main plane (x, y) according to a predefined grid.

3. Transfer method according to the preceding claim, wherein the predefined grid of walls (21) is such that there is at least one transverse direction (D_{T}) in the main plane (x, y) forming a non-zero angle with one flank of each wall (21).

4. Transfer method according to the preceding claim, wherein each wall (21) comprises two longitudinal flanks defined by a length (L) and a height of the wall (h), and two transverse flanks defined by a width (I) and the height (h) of the wall (21), the longitudinal and transverse flanks being perpendicular to the main plane (x, y).

5. Transfer method according to the preceding claim, wherein the length (L) of each wall (21) is greater than the width (I) of each wall (21), and wherein the transverse direction (D_{T}) forms a non-zero angle with a longitudinal flank of each wall (21).

6. Transfer method according to any of claims 3 to 5, wherein the mechanical stress of step b) is a shearing force applied to the detachable layer (20) along the transverse direction (D_{T}).

7. Transfer method according to the preceding claim, wherein the shearing force is applied by means of a roller (5), advancing gradually over the detachable structure (100), in the main plane (x, y) and along the transverse direction (D_{T}), with a determined pressing force.

8. Transfer method according to any of claims 3 to 5, wherein the mechanical stress of step b) is a shock applied to the detachable structure (100), along the transverse direction (D_{T}).

9. Transfer method according to any of claims 3 to 5, wherein the mechanical stress of step b) is a vibrating wave applied to the detachable structure (100), along the transverse direction (D_{T}), and said wave is capable of making the walls (21) oscillate.

10. Transfer method according to any of the preceding claims, wherein each wall (21) has a width (I), in the main plane (x, y), of between 0.1 and 10 microns.

11. Transfer method according to any of the preceding claims, wherein the width of each wall (21) at the lower part (212) in the vicinity of the support substrate (10) is smaller than the width of each wall (21) at the upper part (211) in the vicinity of the superficial layer (30).

12. Transfer method according to any of the preceding claims, wherein the walls (21) have a height (h), perpendicular to the main plane (x, y), of between 0.5 and 5 microns.

13. Transfer method according to any of the preceding claims, wherein each wall (21) has a width (I) in the main plane (x, y) and a height (h) perpendicular to the main plane (x, y) and wherein the height-to-width ratio is greater than 1, preferably greater than 5.

14. Transfer method according to any of the preceding claims, wherein the detachable layer (20) of the detachable structure (100) supplied in step a) is formed by local etching of a layer of silicon oxide (25) arranged on the support substrate (10).

15. Transfer method according to any of claims 1 to 13, wherein the detachable layer (20) of the detachable structure (100) supplied in step a) is formed by local etching of the support substrate (10).

16. Transfer method according to any of the preceding claims, wherein step a) comprises the production of microelectronic components (50) on the superficial layer (30).

17. Transfer method according to any of the preceding claims, comprising, prior to step b), a step of cutting the superficial layer (30) in order to delimit a plurality of local superficial layers to be transferred.
